# EUROPEAN PATENT APPLICATION

(11) **EP 1 271 619 A1**
(43) Date of publication of application: **02.01.2003**
(21) Application number: 01115318.6
(22) Date of filing: 25.06.2001
(51) Int. Cl.: H01L 21/00

(54) **Notched wafer aligning apparatus**

(71) Applicant: Infineon Technologies AG, 81669 München (DE)
(72) Inventor: Ruemmelin, Stefan, 01109 Dresden (DE)
(74) Representative: Epping Hermann & Fischer

(57) **Abstract**

The present invention relates to a notched wafer aligning apparatus for aligning a plurality of wafers prior to processing them in a certain tool.

The notched wafer aligning apparatus comprises a drive axis (4) for rotating the wafers (1), a plurality of wafer wheels (2) arranged on a number of wheel axes (3) for guiding each of the wafers (1), a notch stop (6) to prevent further rotation of each of the wafers as soon as the notch (5) has reached the notch stop, and a main frame (7) for supporting said drive axis (4), said wheel axes (3) and said notch stop (6), wherein the notched wafer aligning apparatus additionally comprises fixtures (9) such as recesses for housing said wafer wheel axes (3), said fixtures (9) being fixedly attached to said main frame (7) and each of said fixtures (9) having a slot extending along part of the inner sidewall of the main frame (7).

## Description

The present invention relates to a notched wafer aligning apparatus. Such an apparatus is usually used for aligning a plurality of wafers so as to enable an easier handling and a reproducible wafer orientation during processing. In particular, such an apparatus forms part of the input/output station of a processing tool such as a wet etching tool. Usually, approximately 25 wafers, which are horizontally held in a cassette, are delivered to the input/output station. They are gripped by 25 grippers at one time, placed to the notched wafer aligning apparatus and, after the alignment procedure, vertically placed into a process carrier.

In order to perform the alignment procedure, the wafers are provided with a notch such as a cutout on their outer periphery. From this notch, also the wafer identification number can be read. Usually, the aligning apparatus for a wafer that is provided with a notch comprises a notch stop for mechanically aligning the wafers. The angular position of the notch stop can arbitrarily set in dependence from the processing conditions.

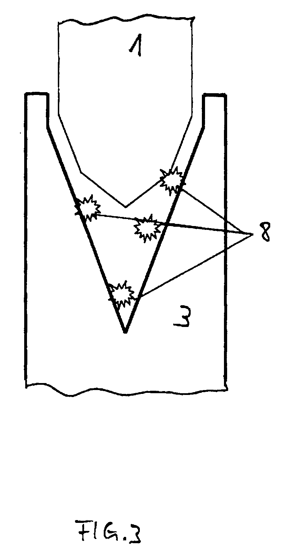

Figure 2 shows a cross sectional view of an exemplary notched wafer aligning apparatus in a direction parallel to the wafer surface. Usually, each wafer 1 is held in a vertical position by four single wafer wheels 2 on the right and on the left sides thereof. In greater detail, the edges of the wafer are engaged with the wafer wheels 2 whereby the wafer is guided. A drive axis 4 is provided which is in contact with the edge of the bottom portion of the wafer. The drive axis is driven by a motor (not shown). By rotating the drive axis 4, the wafer 1 is rotated until the notch 5 arranged in the edge of the wafer klicks into the notch stop 6. The notch stop 6 typically is implemented as a bar perpendicularly to the wafer surfaces in an arbitrary angular position in order to prevent further movement of the wafer 1. The drive axis 4 is rotated until all wafers are engaged with the notch stop 6. Thereby, all wafers are aligned and can be processed as an aligned batch. The wafer wheels are arranged on 4 wafer wheel axes 3. The wafer wheel axes 3, the drive axis 4 and the notch stop 6 are held by a main frame. In particular, all these components are fixed on the main frame by means of screws so that the removal of one of these components requires the dismounting of the whole notched wafer aligning apparatus.

One problem involved with this aligning apparatus is the contamination of the wafer wheels. Usually, the wafer edge is rough and relatively dirty. By sliding and rolling in the wafer wheels, the dirt collects in the wheel and on the drive axis. After a relatively short time of operation such as one day, the wafer wheels as well as the drive axis show a dark coloration caused by particles. In order not to recontaminate the wafer, it is required that the wafer wheels and the drive axis are cleaned every day.

The drive axis is relatively easy to clean since it is basically a rubber roll with very little topography. Moreover, there is only one rubber roll for a plurality of wafers and it does not move while cleaning.

In contrast, there is one single wafer wheel for every wafer on each of the axes, and the wafer wheels are single ball beared wheels which are grooved relatively deeply and which are very easy to rotate. Figure 3 shows the cross-section of such a single wafer wheel 2. As can be seen, contamination particles 8 adhere to the walls of the guidance groove of the wafer wheel. Usually, the cleaning of the single wafer wheels is accomplished by brushing every wheel using a brush. In order to avoid a rotation of the single wheel, every wheel must be held fast. Accordingly, the cleaning of the wafer wheels is very complicated and time consuming.

Since, in addition, during the cleaning operation no wafers can be processed and the tool has to be unloaded completely for safety reasons, the cleaning of the wafer wheels causes unnecessary downtime for the whole tool.

It is therefore an object of the present invention to provide an improved notched wafer aligning apparatus.

According to the present invention, the above object is achieved by a notched wafer aligning apparatus for aligning a plurality of notched wafers arranged in juxtaposition to each other, comprising a drive axis rotated by a motor, said drive axis being in contact with the edges of the wafers so as to rotate the wafers, a plurality of wafer wheels arranged on a number of wheel axes so as to be in engagement with the edges of each of the wafers at a number of positions corresponding to said number of wheel axes, whereby each of the wafers is guided, a notch stop to prevent further rotation of each of the wafers as soon as the notch has reached the notch stop, and a main frame for supporting said drive axis, said wheel axes and said notch stop, wherein said notched wafer aligning apparatus additionally comprises fixtures for housing said wafer wheel axes, said fixtures being fixedly attached to said main frame and each of said fixtures having a slot extending along part of the inner sidewall of the main frame.

As defined above, the notched wafer aligning apparatus comprises a main frame having fixtures for housing the wafer wheel axes. In particular, these fixtures are fixedly attached to said main frame and each of said fixtures has a slot extending along part of the inner sidewall of the main frame for inserting and extracting the wafer wheel axis from the main frame. According to the present invention, these fixtures can be implemented in an arbitrary manner as soon as they enable an easy mounting and demounting of the wafer wheel axes from the main frame. In particular, they can be advantageously be implemented as recesses in the main frame. However, the fixtures can as well be implemented as a kind of tracks which are attached to the inner sidewalls of the main frame by screws.

Accordingly, the wafer wheel axes are easy to be removed from the main frame. As a consequence, they can be cleaned outside the apparatus, and be built in the apparatus after the cleaning process. Thereby, the cleaning process can be performed more easily, it will consume less time and, in particular, will cause a very little downtime of the tool, which results in a better cost of ownership and better uptime.

Moreover, since the wafer wheel axes can easily be removed from the main frame, it is possible to clean the wafer wheels ultrasonically. Thereby, they can be very efficiently and easily cleaned in a clean environment. Accordingly, the use of a brush and the holding of the single wheels is no longer necessary, and the cleaning process can further be improved and simplified.

In particular, if the notched wafer aligning apparatus of the present invention comprises a second set of wafer wheel axes, it is possible to clean the first set of wafer wheels while the second set of wafer wheels is mounted into the main frame so that there is no downtime of the notched wafer aligning apparatus during the cleaning of the wafer wheels. Thereby, the work-load of the apparatus can further be improved which results in reduced cost and a better performance.

In addition, the notched wafer aligning apparatus preferably comprises a number of seals in order to fix the wafer wheel axes in the fixtures. Thereby, a correct positioning of the wafer wheel axes in the main frame is ensured. Of course, the fixing of the wafer wheel can also be accomplished by other fixing elements such as a snap or a screw.

The invention further relates to a method for cleaning the wheels of the above described apparatus. The method comprises the step of removing the wheels from the main frame of the apparatus and placing them into a liquid whereby the liquid is supplied with ultrasonic waves.

In the following, the present invention will be described in detail with reference to the accompanying drawings.
- Figure 1: shows the setup of the notched wafer aligning apparatus according to the present invention;
- Figure 2: shows a cross section of a notched wafer aligning apparatus in a direction parallel to the wafer surface; and
- Figure 3: shows a cross section of a single wafer wheel in a direction perpendicular to the wafer surface.

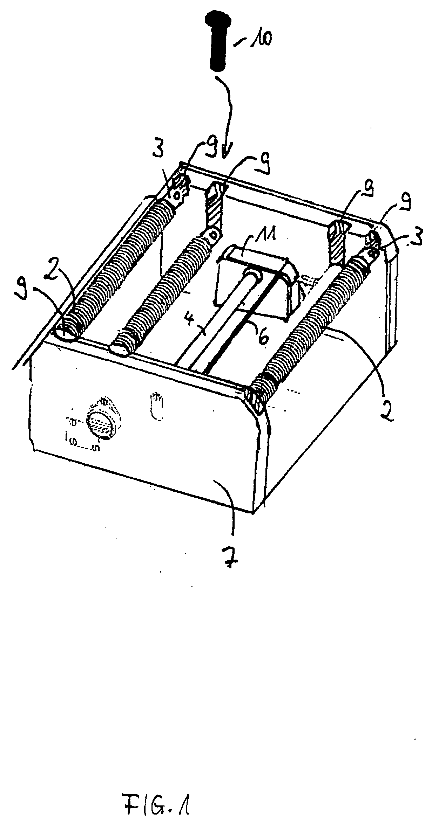

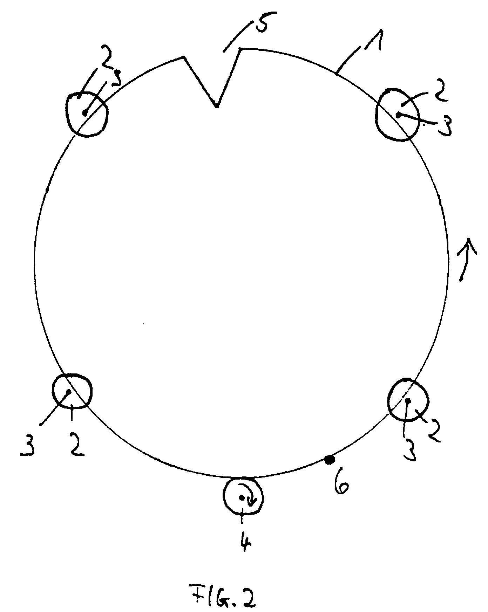

As shown in Figure 1, the notched wafer aligning apparatus comprises a main frame 7 having eight recesses 9 for housing four wafer wheel axes 3 on which a plurality of wafer wheels are arranged, respectively. A drive axis 4, which is driven by a motor 11, for rotating the wafer as well as a notch stop 6 are also mounted to the main frame 7. In the present embodiment, the notch stop 6 is implemented as a bar perpendicularly to the wafer surface. However, as is to be understood, the notch stop 6 can as well be implemented in a different manner so as to prevent the rotation of a wafer as soon as the notch thereof has reached a predetermined position.

The recesses 9 extend along the inner side walls of the main frame 7, respectively, to the upper part thereof. Since the four wafer wheel axes 3 are housed in the recesses 9, they can easily be removed from the main frame by extracting and be replaced by a second set of wafer wheel axes 3. By simply inserting the wafer wheel axes into the recesses, their alignment is likewise accomplished.

In addition, eight seals are provided for fixing the wafer wheel axes in the recesses. However, the wafer wheel axes can also be fixed in the recesses by other means.

Since the wafer wheel axes can easily be removed from the main frame, it is possible to clean them ultrasonically which additionally enables an easier and better cleaning.

In particular, the disengaged rollers can be put into a PVDF (polyvinyldifluoride) megasonic tank which is filled with a mixture of 5:1:1 volume parts of H₂O:H₂O₂:NH₄OH at 80°C for 10 to 30 minutes and megasonic waves at a frequency of 700 to 1000 kHz are applied to the tank. Such a mixture is commonly used for cleaning wafers especially from inorganic particles. Thereafter, the rollers are put onto a megasonic overflow water tank in order to rinse the cleaning solution off the rollers. It is to be noted that megasonic sound is an ultrasonic sound with very high frequency over 1 MHz.

Thereby, a thorough and easy cleaning of the wafer wheels can be accomplished in a comparatively short time. Since the wafer wheel axes are easy to be mounted and dismounted to and from the main frame and, in particular, a second set of wafer wheel axes is provided, the downtime of the tool can largely be reduced whereby the cost can remarkably be reduced and the work load of the tool can be increased.
- 1: wafer
- 2: wafer wheel
- 3: wafer wheel axis
- 4: drive axis
- 5: notch
- 6: notch stop
- 7: main frame
- 8: contamination particles
- 9: recess
- 10: seal

## Claims

1. A notched wafer aligning apparatus for aligning a plurality of wafers (1) arranged in juxtaposition to each other, each of the wafers having a notch at its edge, comprising
- a drive axis (4) rotated by a motor (11), said drive axis being in contact with the edges of the wafers (1) so as to rotate the wafers (1),
- a plurality of wafer wheels (2) arranged on a number of wheel axes (3) so as to be in engagement with the edges of each of the wafers (1) at a number of positions corresponding to said number of wheel axes (3), whereby each of the wafers (1) is guided,
- a notch stop (6) to prevent further rotation of each of the wafers as soon as the notch (5) has reached the notch stop, and
- a main frame (7) for supporting said drive axis (4), said wheel axes (3) and said notch stop (6),
- wherein said notched wafer aligning apparatus additionally comprises fixtures (9) for housing said wafer wheel axes (3), said fixtures (9) being fixedly attached to said main frame (7) and each of said fixtures (9) having a slot extending along part of the inner sidewall of the main frame (7).

2. The notched wafer aligning apparatus according to claim 1, wherein the number of fixtures (9) corresponds to the twofold of the number of wheel axes (3).

3. The notched wafer aligning apparatus according to claim 1 or 2, wherein said fixtures (9) are implemented as recesses in the main frame (7).

4. The notched wafer aligning apparatus according to any of claims 1 to 3, wherein said wafer wheels (2) are adapted to hold the wafers (1) in a vertical position.

5. The notched wafer aligning apparatus according to any of claims 1 to 4, further comprising seals (10) for each of said fixtures (9) for fixing said wheel axes (3) in said fixtures (9).

6. The notched wafer aligning apparatus according to any of claims 1 to 5, further comprising a second set of wafer wheel axes (3).

7. A method for cleaning the wafer wheels of an apparatus according to any of claims 1 to 6 wherein the wheels (2) are removed from the main frame and are placed into a liquid and the liquid is supplied with ultrasonic waves.

8. The method according to claim 7, wherein the liquid comprises H₂O, H₂O₂, and NH₄OH.
